# EUROPEAN PATENT APPLICATION

(11) **EP 4 815 653 A1**
(43) Date of publication of application: **30.09.2026**
(21) Application number: 25305440.7
(22) Date of filing: 26.03.2025
(51) Int. Cl.: H05K 7/20, F16K 31/06

(54) **ELECTRICAL POWER CONVERSION SYSTEM AND ASSOCIATED VEHICLE**

(71) Applicant: ALSTOM Holdings, 93400 Saint-Ouen-sur-Seine (FR)
(72) Inventor: ESCROUZAILLES, Vincent, 65601 Semeac Cedex (FR)
(74) Representative: Plasseraud IP

(57) **Abstract**

The electrical power conversion system (16) comprises:
- a conversion device (24);
- a control device (30) configured for controlling the conversion device depending on a control voltage generated at a first output terminal (32A) of the control device;
- a cooling device (40) comprising :
- a fluidic circuit (42);
- a solenoid valve (46) comprising :
- a body (48) delimiting a fluidic passage (50);
- a plunger (62);
- an electrical coil (68) configured for moving the plunger depending on the control voltage at the input terminal (69);

wherein:
the first output terminal of the control device is electrically connected to a first input terminal (25A) of the conversion device via the electrical coil.

## Description

The present invention concerns an electrical power conversion system of a vehicle.

In such electrical power conversion systems, electrical power conversion devices generate a significant amount of heat.

The generated heat has to be evacuated to ensure a correct functioning of the devices and to increase the lifetime of said devices.

Some electrical power conversion systems comprise a cooling device comprising a fluidic circuit designed to bring a cooling fluid in thermal exchange with the electrical power conversion devices.

In this context, some studies have shown that variable cooling fluid flow can enhance the lifetime of electrical components within the devices. In existing solutions, additional sensors, actuators and electronics are required to ensure an adapted fluid flow.

This is not entirely satisfactory. Indeed, implementing several electronic elements dedicated to the control of the fluid flow increases the complexity of the system and negatively impacts the reliability of the system.

One aim of the invention is to provide an electrical power conversion system in which the cooling of the electrical power conversion devices is carried out in a simpler way.

For this purpose, the invention concerns an electrical power conversion system of a vehicle, comprising:
- an electrical power conversion device comprising a first input terminal, a second input terminal and at least one output terminal, the at least one output terminal being designed to be electrically connected to an electrical load of the vehicle;
- a control device configured for controlling the electrical power conversion device, the control device comprising at least one input terminal, a first output terminal and a second output terminal,
   the first output terminal of the control device being electrically connected to the first input terminal of the electrical power conversion device, the second output terminal of the control device being electrically connected to the second input terminal of the electrical power conversion device,
   the control device being configured for generating a control voltage at the first output terminal of the control device, the electrical power conversion device being configured for being controlled by the control device depending on the control voltage;
- a cooling device configured for cooling the electrical power conversion device, the cooling device comprising:
   - a fluidic circuit comprising at least a conduit at least partially in contact with the electrical power conversion device;
   - a solenoid valve configured for regulating a flowrate of fluid flowing in the at least one conduit, the solenoid valve comprising :
      - a body delimiting a fluidic passage, the fluidic passage being part of the fluidic circuit;
      - a plunger adapted to move within the fluidic passage to modify the flowrate of fluid flowing through the fluidic passage;
      - an electrical coil arranged around the plunger and configured for moving the plunger depending on an electrical input, the electrical coil comprising an input terminal configured for receiving the electrical input and an output terminal;
wherein:
the first output terminal of the control device is electrically connected to the first input terminal of the electrical power conversion device via the electrical coil, the electrical input corresponding to the control voltage.

Thanks to the invention, apart from the solenoid valve, no other electronic specifically dedicated to fluid flow control is necessary. This makes the system simpler since the amount of electronic components and wiring is drastically reduced.

The electrical power conversion system according to the invention may comprise one or more of the following features, taken alone or in any technically feasible combination:
- the first output terminal of the control device is electrically connected to the input terminal of the electrical coil and the output terminal of the electrical coil is electrically connected to the first input terminal of the electrical power conversion device;
- the control device is configured for generating a control voltage at the first output terminal of the control device depending on a command voltage at the at least one input terminal of the control device;
- the control device comprises for each input terminal of the control device:

- a switching branch comprising two switching half-branches connected in series between the first output terminal and the second output terminal of the control device, the two switching half-branches being connected to each other at an intermediate point, the intermediate point being electrically connected to the corresponding input terminal of the control device, each switching half-branch comprising at least one diode and/or at least one transistor, for example an IGBT or MOSFET type transistor;
   - the electrical power conversion device is a voltage source inverter;
   - the body of the solenoid valve comprises a tubular duct extending along a longitudinal axis and delimiting the fluidic passage,
a portion of the tubular duct being such that the cross section of a portion of fluidic passage delimited by said portion of the tubular duct varies along the longitudinal axis, the plunger being adapted to move in the portion of the fluidic passage delimited by said portion of the tubular duct to modify the flowrate of fluid flowing through the fluidic passage between the plunger and the portion of tubular duct;
- the portion of the tubular duct extends along the longitudinal axis between an upstream end at an upstream coordinate and a downstream end at a downstream coordinate,
the cross-section of the portion of fluidic passage delimited by said portion of the tubular duct being maximum at the upstream coordinate and downstream coordinate and being minimum at an intermediate coordinate arranged between the upstream and downstream coordinates;
- the plunger has substantially the shape of a disc extending substantially perpendicular to the longitudinal axis, the plunger extending along the longitudinal axis between an upstream face and a downstream face, the radius of the plunger being minimum at the upstream face and downstream face and being maximum at a middle section of the plunger arranged halfway between the upstream and downstream faces;
- the solenoid valve further comprises:
   - a support mounted onto the body and extending across the fluidic passage substantially perpendicular to the longitudinal axis;
   - a rod mounted onto the support and extending within the fluidic passage along the longitudinal axis, the rod being able to slide onto the support along the longitudinal axis; the plunger being mounted onto the rod,
the plunger and/or the rod being made up of a ferromagnetic material.

The invention also concerns a vehicle, in particular railway vehicle, comprising:
- an electrical power conversion system as described above;
- an electrical load, for example an electrical motor;
the at least one output terminal of the electrical power conversion device being electrically connected to the electrical load of the vehicle.

The invention will be better understood upon reading the following description, given only as an example and made with reference to the appended drawings, in which:

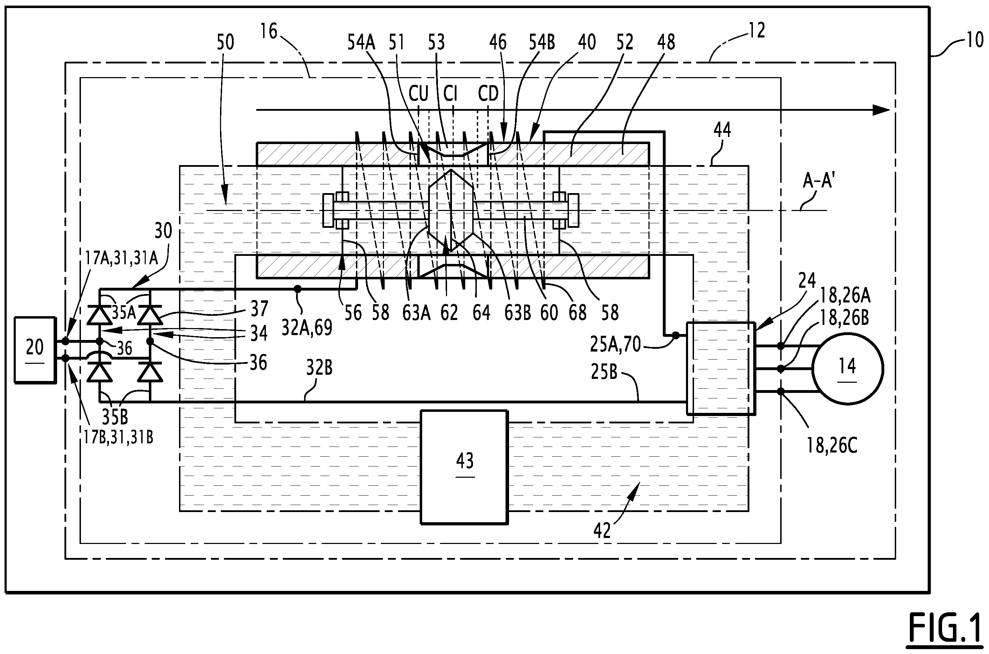

- Figure 1 is a schematic illustration of a vehicle according to the invention.

A vehicle 10 according to the invention is described.

For example, the vehicle 10 is a railway vehicle.

The vehicle 10 comprises an electrical load 14 and an electrical power conversion system 16.

Advantageously, the vehicle 10 further comprises a drive chain 12 and the drive chain 12 comprises the electrical load 14 and the electrical power conversion system 16.

The electrical load 14 is for example an electrical motor.

For example, the electrical motor is a three-phase motor.

The electrical power conversion system 16 is configured for converting a first electrical energy into a second electrical energy.

In particular, the electrical power conversion system 16 is configured to convert a continuous electrical energy provided by a continuous bus 20 into an alternative electrical energy, such as a three-phase electrical energy, provided to the electrical load 14.

Notably, as shown on figure 1, the electrical power conversion system 16 is designed to receive a continuous voltage from the continuous bus 20 and deliver an alternative voltage to the electrical load 14.

The electrical power conversion system 16 comprises an electrical power conversion device 24, a control device 30 and a cooling device 40.

The electrical power conversion system 16 comprises two input terminals 17A, 17B associated with the first electrical energy and at least one output terminal 18 associated with the second electrical energy.

The electrical power conversion device 24 is advantageously a voltage source inverter.

The electrical power conversion device 24 is configured for being controlled by the control device 40 depending on a control voltage.

The electrical power conversion device 24 comprises a first input terminal 25A, a second input terminal 25B and at least one output terminal 26.

In the example of figure 1, the electrical power conversion device 24 comprises three output terminals 26A, 26B, 26C, each output terminal 26A, 26B, 26C corresponding to one phrase of the three-phase AC energy.

Advantageously, the at least one output terminal 26 of the electrical power conversion device 24 corresponds to the at least one output terminal 18 of the electrical power conversion system 16.

The at least one output terminal 26 of the electrical power conversion device 24 is electrically connected to the electrical load 14 of the vehicle 10.

The control device 30 is configured for controlling the electrical power conversion device 24.

The control device 30 comprises at least one input terminal 31, a first output terminal 32A and a second output terminal 32B.

In the example of figure 1, the control device 30 comprises two input terminals 31A, 31B. Advantageously, the two input terminals 31A, 31B of the control device 30 correspond to the two input terminals 17A, 17B of the electrical power conversion system 16.

The first output terminal 32A of the control device 30 is electrically connected to the first input terminal 25A of the electrical power conversion device 24.

In particular, the first output terminal 32A of the control device 30 is electrically connected to the first input terminal 25A of the electrical power conversion device 24 via an electrical coil 68 of the cooling device 40.

Advantageously, the first output terminal 32A of the control device 30 is electrically connected to an input terminal 69 of the electrical coil 68.

The second output terminal 32B of the control device 30 is electrically connected to the second input terminal 25B of the electrical power conversion device 24.

The control device 30 is configured for generating the control voltage at the first output terminal 32A of the control device 30, in particular depending on a command voltage at the at least one input terminal 31 of the control device 30.

Advantageously, the control device 30 comprises, for each input terminal 31 of the control device 30, a switching branch 34 comprising two switching half-branches 35A, 35B connected in series between the first output terminal 32A and the second output terminal 32B of the control device 30.

The two switching half-branches 35A, 35B are connected to each other at an intermediate point 36.

The intermediate point 36 is electrically connected to the corresponding input terminal 31 of the control device 30.

Each switching half-branch 35A, 35B comprises at least one diode 37, as shown on the example of figure 1, and/or at least one transistor, for example an IGBT or MOSFET type transistor.

The cooling device 40 is configured for cooling the electrical power conversion device 24.

The cooling device 40 comprises a fluidic circuit 42 and a solenoid valve 46.

Advantageously, the cooling device 40 further comprises an actuator 43.

The fluidic circuit 42 comprises at least a conduit 44 at least partially in contact with the electrical power conversion device 24. In particular, the at least one conduit 44 passes through the electrical power conversion device 24.

The at least one conduit 44 is designed to host the flow of a cooling fluid, for example water, notably glycol water, or oil, notably mineral oil or vegetable oil.

Advantageously, the actuator 43 is configured for moving the cooling fluid within the fluidic circuit 42, in particular within the at least one conduit 44. The actuator 43 is for example a pump.

The solenoid valve 46 is configured for regulating a flowrate of the fluid flowing in the at least one conduit 44.

The solenoid valve 46 comprises a body 48, a plunger 62 and the electrical coil 68.

Advantageously, the solenoid valve 46 further comprises a support 56 and a rod 60.

The body 48 delimits a fluidic passage 50.

In particular, the body 48 comprises a tubular duct 52 extending along a longitudinal axis A-A' and delimiting the fluidic passage 50.

The fluidic passage 50 is part of the fluidic circuit 42.

A portion 53 of the tubular duct 52 is such that the cross section of the portion 51 of fluidic passage 50 delimited by said portion 53 of the tubular duct 52 varies along the longitudinal axis A-A'.

The portion 53 of the tubular duct 52 extends along the longitudinal axis A-A' between an upstream end 54A at an upstream coordinate CU and a downstream end 54B at a downstream coordinate CD.

The cross-section of the portion 51 of fluidic passage 50 delimited by said portion 53 of the tubular duct 52 is maximum at the upstream coordinate CU and downstream coordinate CD and is minimum at an intermediate coordinate Cl arranged between the upstream CU and downstream CD coordinates.

The support 56 is mounted onto the body 48 and extends across the fluidic passage 50 substantially perpendicular to the longitudinal axis A-A'.

In particular, the support 56 comprises two flanges 58 which are arranged on either side of the plunger 62 according to the longitudinal axis A-A'.

The rod 60 is mounted onto the support 56, in particular onto each flange 58, and extends within the fluidic passage 50 along the longitudinal axis A-A'.

The rod 60 is able to slide onto the support 56, in particular onto each flange 58, along the longitudinal axis A-A'.

For example, the rod 60 is made up of a ferromagnetic material. In particular, the rod 60 is able to be moved by the magnetic field generated by the electrical coil 68.

The plunger 62 is adapted to move within the fluidic passage 50 to modify the flowrate of fluid flowing through the fluidic passage 50.

In particular, the plunger 62 is adapted to move, notably in translation along the longitudinal axis A-A', in the portion 51 of the fluidic passage 50 delimited by the portion 53 of the tubular duct 52 to modify the flowrate of fluid flowing through the fluidic passage 50 between the plunger 62 and the portion 53 of tubular duct 52.

Advantageously, the plunger 62 has substantially the shape of a disc extending substantially perpendicular to the longitudinal axis A-A'.

The plunger 62 extends along the longitudinal axis A-A' between an upstream face 63A and a downstream face 63B.

The radius of the plunger 62, measured perpendicularly to the longitudinal axis A-A', is minimum at the upstream face 63A and downstream face 63B and is maximum at a middle section 64 of the plunger 62 arranged halfway between the upstream 63A and downstream 63B faces.

Advantageously, the plunger 62 is mounted onto the rod 60.

Advantageously again, the plunger 62 is made up of a ferromagnetic material. In particular, the plunger 62 is able to be moved by the magnetic field generated by the electrical coil 68.

The electrical coil 68 is arranged around the plunger 62, in particular around the body 48, notably around the tubular duct 52.

The electrical coil 68 has an axis which is substantially coaxial with the longitudinal axis A-A'.

The electrical coil 68 is configured for moving the plunger 62 depending on an electrical input.

In particular, the electrical coil 68 is configured for generating a magnetic field within the fluidic passage 50 depending on the electrical input, said magnetic field being able to move the plunger 62.

The electrical coil 68 comprises the input terminal 69 configured for receiving the electrical input and an output terminal 70.

The electrical input corresponds to the control voltage.

Advantageously, the output terminal 70 of the electrical coil 68 is electrically connected to the first input terminal 25A of the electrical power conversion device 24.

Thanks to the invention, the flowrate of fluid flowing through the fluidic circuit 42 is controlled directly depending on the control voltage generated by the control device 30. The system of the invention therefore does not require any specific electronic for controlling the flowrate of fluid. The system is thus simplified and the overall reliability is improved.

## Claims

1. Electrical power conversion system (16) of a vehicle (10), comprising:
- an electrical power conversion device (24) comprising a first input terminal (25A), a second input terminal (25B) and at least one output terminal (26), the at least one output terminal (26) being designed to be electrically connected to an electrical load (14) of the vehicle (10);
- a control device (30) configured for controlling the electrical power conversion device (24), the control device (30) comprising at least one input terminal (31), a first output terminal (32A) and a second output terminal (32B),
the first output terminal (32A) of the control device (30) being electrically connected to the first input terminal (25A) of the electrical power conversion device (24), the second output terminal (32B) of the control device (30) being electrically connected to the second input terminal (25B) of the electrical power conversion device (24),
the control device (30) being configured for generating a control voltage at the first output terminal (32A) of the control device (30), the electrical power conversion device (24) being configured for being controlled by the control device (30) depending on the control voltage;
- a cooling device (40) configured for cooling the electrical power conversion device (24), the cooling device (40) comprising:
- a fluidic circuit (42) comprising at least a conduit (44) at least partially in contact with the electrical power conversion device (24);
- a solenoid valve (46) configured for regulating a flowrate of fluid flowing in the at least one conduit (44), the solenoid valve (46) comprising :
- a body (48) delimiting a fluidic passage (50), the fluidic passage (50) being part of the fluidic circuit (42);
- a plunger (62) adapted to move within the fluidic passage (50) to modify the flowrate of fluid flowing through the fluidic passage (50);
- an electrical coil (68) arranged around the plunger (62) and configured for moving the plunger (62) depending on an electrical input, the electrical coil (68) comprising an input terminal (69) configured for receiving the electrical input and an output terminal (70);
wherein:
the first output terminal (32A) of the control device (30) is electrically connected to the first input terminal (25A) of the electrical power conversion device (24) via the electrical coil (68),
the electrical input corresponding to the control voltage.

2. Electrical power conversion system (16) according to claim 1, wherein the first output terminal (32A) of the control device (30) is electrically connected to the input terminal (69) of the electrical coil (68) and the output terminal (70) of the electrical coil (68) is electrically connected to the first input terminal (25A) of the electrical power conversion device (24).

3. Electrical power conversion system (16) according to claim 1 or 2, wherein the control device (30) is configured for generating a control voltage at the first output terminal (32A) of the control device (30) depending on a command voltage at the at least one input terminal (31) of the control device (30).

4. Electrical power conversion system (16) according to any one of the preceding claims, wherein the control device (30) comprises for each input terminal (31) of the control device (30):
- a switching branch (34) comprising two switching half-branches (35A, 35B) connected in series between the first output terminal (32A) and the second output terminal (32B) of the control device (30), the two switching half-branches (35A, 35B) being connected to each other at an intermediate point (36) , the intermediate point (36) being electrically connected to the corresponding input terminal (31A, 31B) of the control device (30), each switching half-branch (35A, 35B) comprising at least one diode (37) and/or at least one transistor, for example an IGBT or MOSFET type transistor.

5. Electrical power conversion system (16) according to any one of the preceding claims, wherein the electrical power conversion device (24) is a voltage source inverter.

6. Electrical power conversion system (16) according to any one of the preceding claims, wherein the body (48) of the solenoid valve (46) comprises a tubular duct (52) extending along a longitudinal axis (A-A') and delimiting the fluidic passage (50),
a portion (53) of the tubular duct (52) being such that the cross section of a portion (51) of fluidic passage (50) delimited by said portion (53) of the tubular duct (52) varies along the longitudinal axis (A-A'), the plunger (62) being adapted to move in the portion (51) of the fluidic passage (50) delimited by said portion (53) of the tubular duct (52) to modify the flowrate of fluid flowing through the fluidic passage (50) between the plunger (62) and the portion (53) of tubular duct (52).

7. Electrical power conversion system (16) according to claim 6, wherein the portion (53) of the tubular duct (52) extends along the longitudinal axis (A-A') between an upstream end (54A) at an upstream coordinate (CU) and a downstream end (54B) at a downstream coordinate (CD),
the cross-section of the portion (51) of fluidic passage (50) delimited by said portion (53) of the tubular duct (52) being maximum at the upstream coordinate (CU) and downstream coordinate (CD) and being minimum at an intermediate coordinate (CI) arranged between the upstream (CU) and downstream (CD) coordinates.

8. Electrical power conversion system (16) according to claim 7, wherein the plunger (62) has substantially the shape of a disc extending substantially perpendicular to the longitudinal axis (A-A'), the plunger (62) extending along the longitudinal axis (A-A') between an upstream face (63A) and a downstream face (63B), the radius of the plunger (62) being minimum at the upstream face (63A) and downstream face (63B) and being maximum at a middle section (64) of the plunger (62) arranged halfway between the upstream (63A) and downstream (63B) faces.

9. Electrical power conversion system (16) according to claim 8, wherein the solenoid valve (46) further comprises:
- a support (56) mounted onto the body (48) and extending across the fluidic passage (50) substantially perpendicular to the longitudinal axis (A-A');
- a rod (60) mounted onto the support (56) and extending within the fluidic passage (50) along the longitudinal axis (A-A'), the rod (60) being able to slide onto the support (56) along the longitudinal axis (A-A');
the plunger (62) being mounted onto the rod (60),
the plunger (62) and/or the rod (60) being made up of a ferromagnetic material.

10. Vehicle (10), in particular railway vehicle, comprising:
- an electrical power conversion system (16) according to any one of the preceding claims;
- an electrical load (14), for example an electrical motor;
the at least one output terminal (26) of the electrical power conversion device (24) being electrically connected to the electrical load (14) of the vehicle (10).
